# EUROPÄISCHE PATENTSCHRIFT

(11) **EP 0 799 850 B1**
(45) Veröffentlichungstag und Bekanntmachung des Hinweises auf die Patenterteilung: **26.09.2001**
(21) Anmeldenummer: 97103930.0
(22) Anmeldetag: 10.03.1997
(51) Int. Cl.: C08G 59/30, C08G 59/40

(54) **Phosphormodifizierte Epoxidharze und ein Verfahren zu ihrer Herstellung**
Phosphorus modified epoxy resins and a method for their preparation
Résiunes époxydes modifiées par du phosphore et un procédé pour leur préparation

(30) Priorität: 01.04.1996 DE 19613063
(43) Veröffentlichungstag der Anmeldung: 08.10.1997
(73) Patentinhaber: Clariant GmbH, 65929 Frankfurt am Main (DE)
(72) Erfinder: Hörold, Sebastian, Dr., 50374 Erftstadt (DE); Kleiner, Hans-Jerg, Dr., 61476 Kronberg (DE)

(56) Entgegenhaltungen:
- EP-A- 0 412 425
- EP-A- 0 665 237
- DE-A- 2 920 718
- DE-A- 4 308 185
- DE-A- 4 436 079
- GB-A- 1 031 369
- US-A- 3 236 863
- CHEMICAL ABSTRACTS, vol. 121, no. 6, 8.August 1994 Columbus, Ohio, US; abstract no. 59359, TOKUTAKE, M. : "Epoxy resin-based thermosetting resin films with excellent fire resistance and flexibility" XP002031780 & JP 06 080 765 A (NIPPON ESTER CO) 22.März 1994

## Beschreibung

Die vorliegende Erfindung betrifft phosphormodifizierte Epoxidharze, ein Verfahren zu ihrer Herstellung und ihre Verwendung. Die Harze zeichnen sich durch ihre Flammwidrigkeit und ihre gute Lagerstabilität aus.

Epoxidharze werden heute zur Herstellung von Formmassen und Beschichtungen mit hohen thermischen, mechanischen und elektronischen Eigenschaften eingesetzt. Sie sind geeignet zum Verguß von elektrischen bzw. elektronischen Bauteilen und für Tränk- und Imprägnierprozesse. In der Elektrotechnik werden die verwendeten Epoxidharz-Formmassen überwiegend flammwidrig ausgerüstet.

Epoxidharz-Formmassen werden im allgemeinen mit bromhaltigen aromatischen Verbindungen, insbesondere Tetrabrombisphenol A, flammwidrig ausgerüstet. Werden ausschließlich bromierte Flammschutzmittel eingesetzt, so wird ein Bromgehalt von etwa 20% benötigt, um ein Selbstverlöschen der Formmassen zu gewährleisten. Als Synergist wird häufig Antimontrioxid verwendet. Im Brandfall wird Bromwasserstoff freigesetzt, was zu Schäden durch Korrrosion führen kann. Unter ungünstigen Bedingungen können auch polybromierte Dibenzodioxine und Furane entstehen. Es besteht von daher ein Bedarf an Epoxidharz-Formmassen, die die geforderte Flammwidrigkeit ohne Zusatz bromierter Verbindungen erreichen.

Zur flammwidrigen Ausrüstung von Epoxidharz-Formmassen wurden Füllstoffe mit Löschwirkung wie Aluminiumoxidhydrat (DE 35 40 524 A1) vorgeschlagen. Auch durch den Zusatz von Ammoniumpolyphosphat, gegebenenfalls in Kombination mit Aluminiumoxidhydrat, kann eine hinreichende Flammwidrigkeit erreicht werden. Anstelle von Ammoniumpolyphosphat kann auch roter Phosphor verwendet werden (DE 17 45 796 A1).

Nachteilig bei allen als Füllstoff vorliegenden Flammschutzmitteln ist, daß keine Transparenz der Materialien erhalten wird. Es wurden bereits zahlreiche flüssige phosphororganische Verbindungen als flammhemmende Kunststoffzusätze vorgeschlagen. Nachteilig bei diesen Systemen ist aber der ausgeprägte "Weichmachereffekt" dieser Zusätze. Bei gehärteten Epoxidharzen äußert sich der weichmachende Effekt in einer starken Herabsetzung der Glasübergangstemperatur.

Die flammwidrige Ausstattung von Epoxidharzen mit epoxidfunktionellen Phosphonsäureestern ist bereits beschrieben (DE 0 384 939A1). Nachteilig bei diesen Systemen ist der hohe Syntheseaufwand derartiger Phosphonsäureester. In der Literatur bekannt sind auch phosphormodifizierte Epoxidharze, die durch Umsetzung von Polyepoxidverbindungen mit Anhydriden von Phosphonsäuren oder Phosphinsäuren erhalten werden und sich durch ihre flammwidrige Eigenschaften auszeichnen (DE 43 08 185 A1). Technisch leichter zugänglich als Phosphonsäureanhydride sind phosphorhaltigen Dicarbonsäuren oder phosphorhaltigen Carbonsäureanhydride, die beispielsweise zur flammfesten Ausrüstung von Polyesterfasern verwendet werden (US 4,127,590).

Aufgabe der Erfindung war es, phosphormodifizierte Epoxidharze zur Verfügung zu stellen, die einfach und kostengünstig herzustellen sind, eine hohe Lagerstabilität aufweisen und eine Variation des Phosphorgehalts erlauben.

Diese Aufgabe wird gelöst durch ein phosphormodifiziertes Epoxidharz mit einem Epoxidwert von 0,05 bis 0,6 mol/100g, enthaltend Struktureinheiten, die sich ableiten von
(A) Polyepoxidverbindungen mit mindestens zwei Epoxidgruppen pro Molekül und
(B) phosphorhaltigen Dicarbonsäuren oder phosphorhaltigen Carbonsäureanhydriden

Die erfindungsgemäß verwendeten phosphorhaltigen Dicarbonsäuren oder phosphorhaltigen Carbonsäureanhydride leiten sich von den allgemeinen Formeln (I) oder (II) ab: 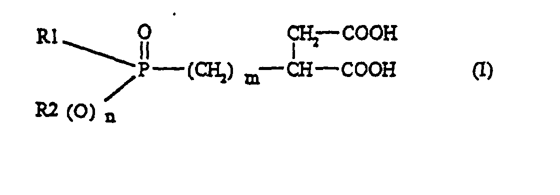 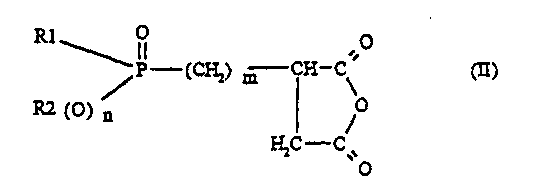 worin R1 und R2 gleich oder verschieden sind und für einen geradkettigen oder verzeigten Alkylrest mit 1 bis 8 C-Atomen, einen Cyclohexyl-, Cyclopentyl-, einen Aryl, einen alkyl- oder alkoxysubstituierten Arylrest mit 1 bis 18 C-Atomen stehen, wobei R1 und R2 zusammen mit dem P-Atom auch einen Ring bilden können und m, n für 0 oder 1 stehen.

Bevorzugt enthält das phosphormodifizierte Epoxidharz eine phosphorhaltige Dicarbonsäure der Formel (III)

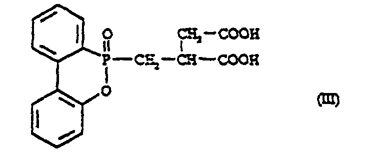

Bevorzugt enthält das phosphormodifizierte Epoxidharz im Mittel mindestens eine Epoxidgruppe.

Bevorzugt enthält das phosphormodifizierte Epoxidharz 0,5 bis 13 Gew.-%, besonders bevorzugt 1 bis 6 Gew.-% Phosphor.

Die vorliegende Aufgabe wird auch gelöst durch ein Verfahren zur Herstellung von phosphormodifizierten Epoxidharzen aus Epoxidharzen und phosphorhaltigen Verbindungen nach Formel (I) oder (II), dadurch gekennzeichnet, daß man die Polyepoxidverbindung gemäß (A) und die phosphorhaltige Dicarbonsäure oder das phosphorhaltige Carbonsäureanhydrid gemäß (B) miteinander umsetzt.

Bevorzugt erfolgt die Umsetzung in einem Lösungsmittel.

Bevorzugt werden als aprotische, polare Lösungsmittel N-methylpyrrolidon, Dimethylformamid, Tetrahydrofuran, Dioxan, Dialkylether, Glykolether, Ketone und/oder Ester eingesetzt.

Bevorzugt werden als Lösungsmittel halogenierte Kohlenwasserstoffe, aliphatische, cycloaliphatische und/oder aromatische Kohlenwasserstoffe, einzeln oder als Gemische, eingesetzt.

Bevorzugt erfolgt die Umsetzung bei Temperaturen zwischen -10 bis +200 °C.

Besonders bevorzugt erfolgt die Umsetzung bei Temperaturen von 70 bis 160 °C.

Bevorzugt beträgt das Äquivalentverhältnis zwischen Polyepoxidverbindung (A) und der phosphorhaltigen Dicarbonsäure oder dem phosphorhaltigen Carbonsäureanhydrid (B) 1:0,1 bis 1:1.

Die Erfindung betrifft auch die Verwendung des erfindungsgemäßen phosphormodifizierten Epoxidharzes oder erhalten nach dem erfindungsgemäßen Verfahren zur Herstellung von Formkörpern, Beschichtungen oder Laminaten.

Schließlich betrifft die Erfindung Formkörper, Beschichtungen oder Laminate, hergestellt unter Verwendung des phosphormodifizierten Epoxidharzes.

Die Herstellung der Phosphorverbindungen kann, wie in der EP 665 237 A1 beschrieben, durch Reaktion von Phosphinoxiden mit Fumar-, Malein- oder Itaconsäureestern und anschließende Hydrolyse der Ester mit Säuren erfolgen.

Die erfindungsgemäß eingesetzten halogenfreien Epoxidverbindungen (im folgenden auch Polyepoxidverbindungen genannt) können gesättigt oder ungesättigt sowie aliphatisch, cycloaliphatisch, aromatisch und/oder heterocyclisch sein. Sie können weiterhin solche Substituenten enthalten, die unter den Mischungs- oder Reaktionsbedingungen keine störenden Nebenreaktionen verursachen, beispielsweise Alkyl- oder Arylsubstituenten, Ethergruppierungen oder ähnliche. Es können auch Gemische verschiedener Polyepoxidverbindungen verwendet werden. Das mittlere Molekulargewicht Mₙ dieser Polyepoxidverbindungen kann bis zu etwa 9000 betragen, liegt jedoch im allgemeinen bei etwa 150 bis 4000.

Beispielsweise handelt es sich bei diesen Polyepoxidverbindungen um Polyglycidylether auf Basis von mehrwertigen, vorzugsweise zweiwertigen Alkoholen, Phenolen, Hydrierungsprodukten dieser Phenole und/oder von Novolaken (Umsetzungsprodukte von ein- oder mehrwertigen Phenolen, wie Phenol und/oder Kresole, mit Aldehyden, insbesondere Formaldehyd in Gegenwart saurer Katalysatoren), die man in bekannter Weise, beispielsweise durch Umsetzung der jeweiligen Polyole mit Epichlorhydrin, erhält.

Als mehrwertige Phenole sind hier beispielsweise zu nennen: Resorcin, Hydrochinon, 2,2-Bis(4-hydroxyphenyl)propan (Bisphenol A), Isomerengemische des Dihydroxydiphenylmethans (Bisphenol F), 4,4'-Dihydroxydiphenylcyclohexan, 4,4'-Dihydroxy-3,3'-dimethyldiphenylpropan, 4,4'-Dihydroxydiphenyl, 4,4'-Dihydroxybenzophenon, Bis(4-hydroxyphenyl)1,1-ethan, Bis(4-hydroxyphenyl)1,1'-isobutan, Bis(4-hydroxy-tert.-butylphenyl)2,2-propan, Bis(2-hydroxynaphthyl)methan, 1,5-Dihydroxynaphthalin, Tris(4-hydroxyphenyl)methan, Bis(4-hydroxyphenyl)1,1'-ether. Bisphenol A und Bisphenol F sind hierbei bevorzugt.

Auch die Polyglycidylether von mehrwertigen aliphatischen Alkoholen sind als Polyepoxidverbindung geeignet. Als Beispiele derartiger mehrwertiger Alkohole seien 1,4-Butandiol, 1,6-Hexandiol, Polyalkylenglykole, Glycerin, Trimethylolpropan, Bis(4-hydroxycyclohexyl)2,2-propan und Pentaerythrit genannt.

Weiter kommen als Polyepoxidverbindungen auch (Poly)glycidester in Frage, die man erhält durch Umsetzung von Epichlorhydrin oder ähnlichen Epoxyverbindungen mit einer aliphatischen, cycloaliphatischen oder aromatischen Polycarbonsäure, wie Oxalsäure, Adipinsäure, Glutarsäure, Phthal-, Isophthal-, Terephthal-, Tetrahydrophthal- oder Hexahydrophthalsäure, 2,6-Naphthalindicarbonsäure und dimerisierte Fettsäuren. Beispiele hierfür sind Terephthalsäurediglycidylester und Hexahydrophthalsäurediglycidylester.

Auch Polyepoxidverbindungen, die die Epoxidgruppen in statistischer Verteilung über die Molekülkette enthalten und die durch Emulsions-Copolymerisation unter Verwendung von olefinisch ungesättigten, diese Epoxidgruppen enthaltenden Verbindungen hergestellt werden können, wie z.B. Glycidylester der Acryl- oder Methacrylsäure, können in manchen Fällen vorteilhaft eingesetzt werden.

Weitere verwendbare Polyepoxidverbindungen sind beispielsweise solche auf der Basis heterocyclischer Ringsysteme, wie z.B. Hydantoinepoxidharze, Triglycidylisocyanurat und/oder dessen Oligomeren, Triglycidyl-p-aminophenol, Triglycidyl-p-aminodiphenylether, Tetraglycidyldiaminodiphenylmethan, Tetraglycidyldiaminodiphenylether, Tetrakis(4-glycidoxyphenyl)ethan, Urazolepoxide, Uracilepoxide, oxazolidinonmodifizierte Epoxidharze. Weiterhin Polyepoxide auf der Basis von aromatischen Aminen, wie Anilin, beispielsweise N,N-Diglycidylanilin, Diaminodiphenylmethan und N,-Dimethylaminodiphenylmethan oder -sulfon. Weitere geeignete Polyepoxidverbindungen sind im "Handbook of Epoxy Resins" von Henry Lee und Kris Neville, McGraw-Hill Book Company, 1967, in der Monographie von Henry Lee "Epoxy Resins", American Chemical Society, 1970, in Wagner/Sarx, "Lackkunstharze", Carl Hanser Verlag (1971), 5. Auflage,174 ff., in der "Angew. Makromol. Chemie", Bd. 44 (1975), Seiten 151 bis 163, in der DE 27 57 733 A1 sowie in der EP 0 384 939 A1 beschrieben, auf die hiermit Bezug genommen wird.

Bevorzugt eingesetzte Polyepoxidverbindungen sind Bisglycidylether auf Basis von Bisphenol A, Bisphenol F und Bisphenol S (Umsetzungsprodukte dieser Bisphenole und Epichlor(halogen)hydrin) oder deren Oligomere, Polyglycidylether von Phenol/Formaldehyd- und/oder Kresol/Formaldehyd-Novolake sowie Diglycidylester der Phthal-, Isophthal-, Terephthal-, Tetrahydrophthal- und/oder Hexahydrophthalsäure sowie der Trimellithsäure, N-Glycidylverbindungen von aromatischen Aminen und heterocyclischen Stickstoffbasen, wie N,N-Diglycidylanilin, N,N,O-Triglycidyl-p-aminophenol, Triglycidylisocyanurat und N,N,N',N'-Tetraglycidylbis(p-aminophenyl)methan, Hydantoin-Epoxidharze und Aracid-Epoxidharze sowie Di- und Polyglycidylverbindungen von mehrwertigen aliphatischen Alkoholen, wie 1,4-Butandiol, Trimethylolpropan und Polyalkylenglykolen.

Des weiteren sind auch oxazolidinonmodifizierte Epoxidharze geeignet. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Die Polyepoxidharze können bei der Herstellung der erfindungsgemäßen Überzugsmasse einzeln oder im Gemisch vorliegen.

Der Ausdruck "Härten", wie er hier gebraucht wird, bedeutet die Umwandlung der löslichen, schmelzbaren Polyepoxide in feste, unlösliche und unschmelzbare, dreidimensional vernetzte Produkte, in der Regel unter gleichzeitiger Formgebung, etwa zu Imprägnierungen, Beschichtungen und Verklebungen.

Als Härter können bespielsweise aliphatische, cycloaliphatische, aromatische und heterocyclische Amine, wie Bis(4-aminophenyl)methan, Anilin-Formaldehyd-Harze, Bis(4-aminophenyl)sulfon, Ethylendiamin, Propan-1,3-diamin, Hexamethylendiamin, Diethylentriamin, Triethylentetramin, 2,2,4-Trimethylhexan-1,6-diamin, m-Xylylendiamin, Bis(4-aminocyclohexyl)methan, 2,2-Bis(4-aminocyclohexyl)propan, 3-Aminomethyl-3,5,5-trimethylcyclohexylamin (Isophorondiamin), Polyamidoamine, Polyphenole, wie Hydrochinon, Resorcin, 2,2-Bis(4-hydroxyphenyl)propan (Bisphenol A) und Phenol-Aldehyd-Harze, Polycarbonsäuren und deren Anhydride, wie zum Beispiel Phtalsäureanhydrid, Tetrahydrophtalsäureanhydrid, Hexahydrophtalsäureanhydrid, Pyromellithsäuredianhydrid eingesetzt werden. Darüber hinaus können auch katalytisch wirkende Härtungsmittel wie Cyanguanidine oder Friedel-Crafts-Katalysatoren wie Bortrifluorid verwendet werden.

Werden Amine als Härtungsmittel verwendet, so werden diese normalerweise in 0,75 bis 1,25 Äquivalenten pro Epoxidäquivalent eingesetzt. Bei Polycarbonsäuren der deren Anhydriden werden 0,4 bis 1,1 Äquivalente pro Epoxidäquivalent verwendet.

Als Beschleuniger kommen vor allem Imidazolderivate, beispielsweise 2-Methylimidazol, 2-Phenylimidazol und 2-Heptadecylimidazol in Frage; weiterhin Phosphine, Metallseifen und Acetylacetonate.

Als Reaktiv-Verdünner kommen beispielsweise mono- oder polyfunktionelle, niedermolekulare Alkohole, die mit Epichlorhydrin umgesetzt werden, in Frage.

Durch Variation des Äquivalentverhältnisses von Polyepoxidverbindung zu phosphorhaltigen Dicarbonsäuren oder phosphorhaltigen Carbonsäureanhydride läßt sich der Phosphorgehalt des erfindungsgemäßen Harzes einstellen. Bevorzugt liegt das Äquivalentverhältnis zwischen 1: 0,1 und 1: 0,8 und besonders bevorzugt zwischen 1:0,1 und 1:0,4. Durch die Umsetzung des Epoxidharzes mit einer phosphorhaltigen Dicarbonsäure oder einem phosphorhaltigen Carbonsäureanhydrid wird ein noch schmelzbares und/oder lösliches, phosphormodifiziertes Epoxidharz erhalten, welches lagerstabil, wahlweise auch in Lösung, und einfach zu handhaben ist.

Falls Lösemittel eingesetzt werden, so sind diese aprotisch und vorzugsweise polar. Beispiele hierfür sind:
N-methylpyrrolidon, Dimethylformamid, Ether wie etwa Diethylether, Tetrahydrofuran, Dioxan, Ethylglykolether, Propylenglykolether, Butylglykolether von Monoalkoholen mit einem ggf. verzweigten Alkylrest von 1 bis 6 Kohlenstoffatomen.

Andere Lösungsmittel sind z.B. Ketone, wie etwa Aceton, Methylethylketon, Methylisopropylketon, Methylisobutylketon, Cyclohexanon und ähnliche, aber auch Ester, wie Ethylacetat, Butylacetat, Ethylenglycolacetat und Methoxypropylacetat können eingesetzt werden.

Weitere geeignete Lösungsmittel sind halogenierte Kohlenwasserstoffe sowie cycloaliphatische und/oder aromatische Kohlenwasserstoffe, bevorzugt sind dabei Hexan, Heptan, Cyclohexan, Toluol sowie Dixylole. Es ist möglich, diese Lösemittel einzeln oder im Gemisch einzusetzen.

Bevorzugt sind die Epoxidharz-Formmassen durch Glasgewebe oder Glasfasern verstärkt. Die Epoxidharz-Formmassen können auch mit Füllstoffen wie Quarzmehl oder Aluminiumoxidhydrat ausgerüstet werden.

Die erfindungsgemäßen Epoxidharz-Formmassen können zur Oberflächenbeschichtung verwendet werden. Sie können für den Verguß elektrischer Bauteile, für Laminate sowie für Klebstoffe verwendet werden.

Nachfolgend wird die Erfindung durch Beispiele erläutert. In den Beispielen 1-4 wurde eine Phosphorverbindung nach Formel (III) verwendet:

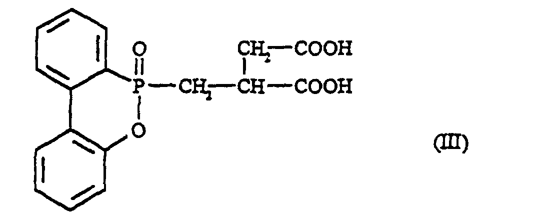

### Herstellung der phosphormodifizierten Epoxidharze

### Beispiel 1

In einem 250 ml Fünfhalskolben mit Rückflußkühler, Rührerwelle, Thermometer und Gaseinleitung werden 100 g eines Bisphenol A-bisglycidylethers mit einem Epoxidwert von 0,55 mol/100g (® Beckopox EP 140, Hoechst AG) und 46,9 g (0,135 mol) der Phosphorverbindung nach Formel m unter Rühren auf maximal 150 °C erhitzt. Nach 30 min ergibt sich eine klare Schmelze. Nach einer weiteren Stunde Rühren bei 150 °C wird die Schmelze abkühlen lassen und gemörsert. Man erhält 146 g eines weißen Pulvers mit einem Epoxidwert von 0,18 mol/100g und einem Phosphorgehalt von 2,85 Gew.-%.

### Beispiel 2

In einem 250 ml Fünfhalskolben mit Rückflußkühler, Rührerwelle, Thermometer und Gaseinleitung werden 100 g eines Bisphenol A-bisglycidylethers mit einem Epoxidwert von 0,55 mol/100g (® Beckopox EP 140, Hoechst AG) und 64,3 g (0,19 mol) der Phosphorverbindung nach Formel III unter Rühren auf maximal 150 °C erhitzt. Nach 30 min ergibt sich eine klare Schmelze. Nach einer weiteren Stunde Rühren bei 150 °C wird die Schmelze abkühlen lassen und gemörsert. Man erhält 164 g eines weißen Pulvers mit einem Epoxidwert von 0,13 mol/100g und einem Phosphorgehalt von 3,47 Gew.-%.

### Beispiel 3

In einem 250 ml Fünfhalskolben mit Rückflußkühler, Rührerwelle, Thermometer und Gaseinleitung werden 100 g eines Bisphenol A-bisglycidylethers mit einem Epoxidwert von 0,55 mol/100g (® Beckopox EP 140, Hoechst AG) und 46,9 g (0,135 mol) der Phosphorverbindung nach Formel III unter Rühren auf maximal 130 °C erhitzt. Während 2,5 h werden 40 ml Isobutylmethylketon dazugegeben. Anschließend wird die klare Lösung noch 1 h bei 120 °C gerührt. Man erhält 177 g einer viskosen Lösung (83%ig) mit einem Epoxidwert von 0,17 mol/100g und einem Phosphorgehalt von 2,37 Gew.-%.

### Beispiel 4

In einem 250 ml Fünfhalskolben mit Rückflußkühler, Rührerwelle, Thermometer und Gaseinleitung werden 100 g eines Bisphenol A-bisglycidylethers mit einem Epoxidwert von 0,55 mol/100g (® Beckopox EP 140, Hoechst AG) und 46,9 g (0,135 mol) der Phosphorverbindung nach Formel III unter Rühren auf maximal 150 °C erhitzt. Beim Abkühlen der homogenen Reaktionsmischung werden 36,7 g Methylethylketon dazugegeben. Man erhält 195 g einer viskosen Lösung (75%ig) mit einem Epoxidwert von 0,11 mol/100g und einem Phosphorgehalt von 2,15 Gew.-%.

### Beispiel 5 (mit Dimethylphosphinyl-methyl-bernsteinsäure (IV))

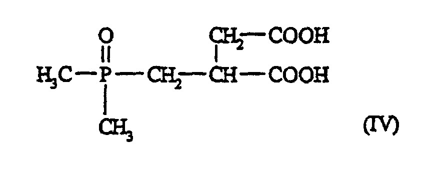

In einem 250 ml Fünfhalskolben mit Rückflußkühler, Rührerwelle, Thermometer und Gaseinleitung werden 100 g eines Bisphenol A-bisglycidylethers mit einem Epoxidwert von 0,55 mol/100g (® Beckopox EP 140, Hoechst AG) und 29 g (0,135 mol) der Phosphorverbindung nach Formel (IV) während 90 min bei 120 °C und 30 min bei 140 °C gerührt. Die klare Schmelze wird nach Abkühlen gemörsert. Man erhält 129 g eines weißen Pulvers mit einem Epoxidwert von 0,19 mol/Kg und einem Phosphorgehalt von 3,3 Gew.-%.

### Beispiel 6 (mit Diphenylphosphinyl-methyl-bernsteinsäure (V))

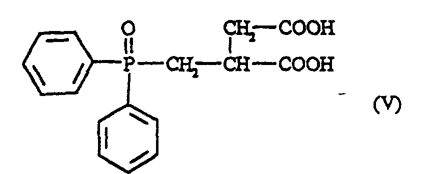

In einem 250 ml Fünfhalskolben mit Rückflußkühler, Rührerwelle, Thermometer und Gaseinleitung werden 100 g eines Bisphenol A-bisglycidylethers mit einem Epoxidwert von 0,55 mol/100g (® Beckopox EP 140, Hoechst AG) und 43 g (0,135 mol) der Phosphorverbindung nach Formel (V) während 90 min bei 120 °C und 30 min bei 140 °C gerührt. Die klare Schmelze wird nach Abkühlen gemörsert. Man erhält 129 g eines weißen Pulvers mit einem Epoxidwert von 0,19 mol/kg und einem Phosphorgehalt von 2,8 Gew.-%.

## Patentansprüche

1. Phosphormodifiziertes Epoxidharz mit einem Epoxidwert von 0,05 bis 0,6 mol/100g, enthaltend Struktureinheiten, die sich ableiten von
(A) Polyepoxidverbindungen mit mindestens zwei Epoxidgruppen pro Molekül und
(B) phosphorhaltigen Dicarbonsäuren oder phosphorhaltigen Carbonsäureanhydriden

2. Phosphormodifiziertes Epoxidharz nach Anspruch 1, **dadurch gekennzeichnet, daß** sich die Struktureinheiten (B) von Phosphorverbindungen der allgemeinen Formel (I) oder (II) ableiten 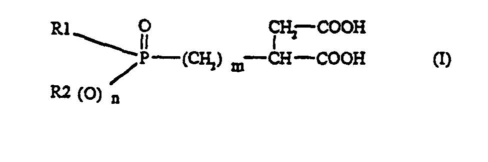 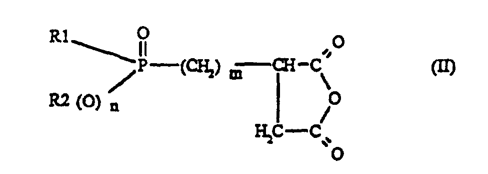 worin R1 und R2 gleich oder verschieden sind und für einen geradkettigen oder verzeigten Alkylrest mit 1 bis 8 C-Atomen, einen Cyclohexyl-, Cyclopentyl-, einen Aryl, einen alkyl- oder alkoxysubstituierten Arylrest mit 1 bis 18 C-Atomen stehen, wobei R1 und R2 zusammen mit dem P-Atom auch einen Ring bilden können und m, n für 0 oder 1 stehen.

3. Phosphormodifiziertes Epoxidharz nach Anspruch 1 oder 2, **dadurch gekennzeichnet, daß** es eine phosphorhaltige Dicarbonsäure der Formel (III) 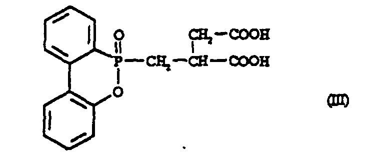 enthält.

4. Phosphormodifiziertes Epoxidharz nach einem oder mehreren der Ansprüche 1 bis 3, **dadurch gekennzeichnet, daß** es im Mittel mindestens eine Epoxidgruppe enthält.

5. Phosphormodifiziertes Epoxidharz nach einem oder mehreren der Ansprüche 1 bis 4, **dadurch gekennzeichnet**, das es 0,5 bis 13 Gew.-% Phosphor enthält.

6. Verfahren zur Herstellung von phosphormodifizierten Epoxidharzen aus Epoxidharzen und phosphorhaltigen Verbindungen nach Formel (I) oder (II), **dadurch gekennzeichnet, daß** man die Polyepoxidverbindung gemäß (A) und die phosphorhaltige Dicarbonsäure oder das phosphorhaltige Carbonsäureanhydrid gemäß (B) miteinander umsetzt.

7. Verfahren nach Anspruch 6, **dadurch gekennzeichnet, daß** die Umsetzung in einem Lösungsmittel erfolgt.

8. Verfahren nach Anspruch 7, **dadurch gekennzeichnet, daß** aprotische, polare Lösungsmittel, wie N-methylpyrrolidon, Dimethylformamid, Tetrahydrofuran, Dioxan, Dialkylether, Glykolether, Ketone und/oder Ester eingesetzt werden.

9. Verfahren nach Anspruch 7, **dadurch gekennzeichnet, daß** als Lösungsmittel halogenierte Kohlenwasserstoffe, aliphatische, cycloaliphatische und/oder aromatische Kohlenwasserstoffe, einzeln oder als Gemische, eingesetzt werden.

10. Verfahren nach einem oder mehreren der Ansprüche 6 bis 9, **dadurch gekennzeichnet, daß** die Umsetzung bei Temperaturen zwischen -10 bis +200 °C erfolgt.

11. Verfahren nach Anspruch 10, **dadurch gekennzeichnet, daß** die Umsetzung bei Temperaturen von 70 bis 160 °C erfolgt

12. Verfahren nach einem oder mehreren der Ansprüche 6 bis 11, **dadurch gekennzeichnet, daß** das Äquivalentverhältnis zwischen Polyepoxidverbindung (A) und der phosphorhaltigen Dicarbonsäure oder dem phosphorhaltigen Carbonsäureanhydrid (B) 1:0,1 bis 1:1 beträgt.

13. Verwendung des phosphormodifizierten Epoxidharzes nach einem oder mehreren der Ansprüche 1 bis 5 oder erhalten nach einem der Ansprüche 6 bis 12 zur Herstellung von Formkörpern, Beschichtungen oder Laminaten.

## Claims

1. A phosphorus-modified epoxy resin having an epoxide value of from 0.05 to 0.6 mol/100 g, comprising structural units derived from
(A) polyepoxide compounds having at least two epoxide groups per molecule and
(B) phosphorus-containing dicarboxylic acids or phosphorus-containing carboxylic anhydrides.

2. A phosphorus-modified epoxy resin as claimed in claim 1, wherein the structural units (B) derive from phosphorus compounds of the formula (I) or (II) 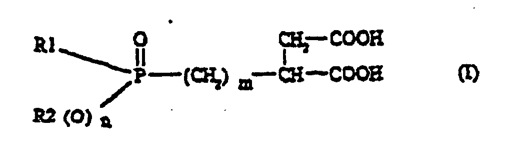 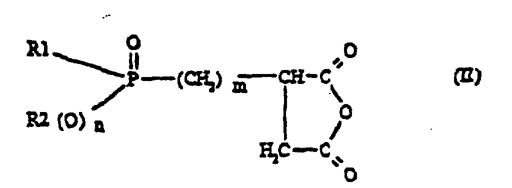 in which R1 and R2 are identical or different and are a straight-chain or branched alkyl radical of 1 to 8 carbon atoms, a cyclohexyl, cyclopentyl or aryl radical or an alkyl- or alkoxy-substituted aryl radical of 1 to 18 carbon atoms, in which R1 and R2, together with the P atom, may also form a ring, and m and n are 0 or 1.

3. A phosphorus-modified epoxy resin as claimed in claim 1 or 2, which comprises a phosphorus-containing dicarboxylic acid of the formula (III)

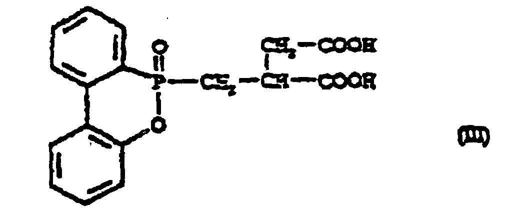

4. A phosphorous-modified epoxy resin as claimed in one or more of claims 1 to 3, which contains on average at least one epoxide group.

5. A phosphorus-modified epoxy resin as claimed in one or more of claims 1 to 4, which contains from 0.5 to 13 % by weight of phosphorus.

6. A process for preparing a phosphorus-modified epoxy resin comprising epoxy resins and phosphorus-containing compounds of formula (I) or (II), which comprises reacting the polyepoxide compound of (A) and the phosphorus-containing dicarboxylic acid or the phosphorus-containing carboxylic anhydride of (B) with one another.

7. The process as claimed in claim 6, wherein the reaction takes place in a solvent.

8. The process as claimed in claim 7, wherein aprotic polar solvents such as N-methylpyrrolidone, dimethylformamide, tetrahydrofuran, dioxane, dialkyl ethers, glycol ethers, ketones and/or esters are employed.

9. The process as claimed in claim 7, wherein solvents employed are halogenated hydrocarbons, aliphatic, cycloaliphatic and/or aromatic hydrocarbons, individually or as mixtures.

10. The process as claimed in one or more of claims 6 to 9, wherein the reaction takes place at temperatures of between -10 and +200°C.

11. The process as claimed in claim 10, wherein the reaction takes place at temperatures from 70 to 160°C.

12. The process as claimed in one or more of claims 6 to 11, wherein the ratio of equivalents between polyepoxide compound (A) and the phosphorus-containing dicarboxylic acid or the phosphorus-containing carboxylic anhydride (B) is from 1:0.1 to 1:1.

13. The use of a phosphorus-modified epoxy resin as claimed in one or more of claims 1 to 5 or obtained as claimed in one of claims 6 to 12 for producing moldings, coatings

## Revendications

1. Résine époxyde modifiée par du phosphore ayant un indice d'époxyde compris entre 0,05 et 0,6 mol/100 g, contenant des motifs de structure qui dérivent de
(A) composés polyépoxyde ayant au moins deux groupes époxyde par molécule et
(B) d'acides dicarboxyliques contenant du phosphore ou d'anhydrides carboxyliques contenant du phosphore.

2. Résine époxyde modifiée par du phosphore selon la revendication 1, **caractérisée en ce que** les motifs de structure (B) dérivent de composés du phosphore de formule générale (I) ou (II) 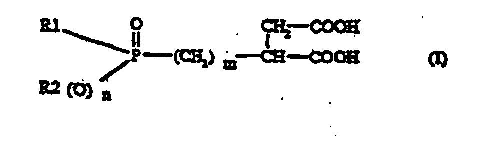 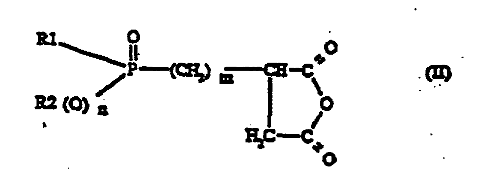 dans lesquelles R1 et R2 sont identiques ou différents et représentent un résidu alkyle à chaîne linéaire ou ramifiée ayant de 1 à 8 atomes de carbone, un groupe cyclohexyle, cyclopentyle, aryle, aryle substitué avec un groupe alkyle ou alcoxy, ayant de 1 à 18 atomes de carbone, R1 et R2 pouvant également former ensemble un cycle avec l'atome P, et m, n représentent 0 ou 1.

3. Résine époxyde modifiée par du phosphore selon la revendication 1 ou 2, **caractérisée en ce qu'**elle contient un acide dicarboxylique contenant du phosphore de formule (III)

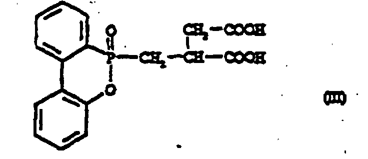

4. Résine époxyde modifiée par du phosphore selon une ou plusieurs des revendications 1 à 3, **caractérisée en ce qu'**elle contient en moyenne au moins un groupe époxyde.

5. Résine époxyde modifiée par du phosphore selon une ou plusieurs des revendications 1 à 4, **caractérisée en ce qu'**elle contient de 0,5 à 13% en poids de phosphore.

6. Procédé pour la préparation de résines époxydes et de composés contenant du phosphore selon la formule (I) ou (II), **caractérisé en ce qu'**on met à réagir l'un avec l'autre le composé polyépoxyde selon (A) et l'acide dicarboxylique contenant du phosphore ou l'anhydride dicarboxylique contenant du phosphore selon (B).

7. Procédé selon la revendication 6, **caractérisé en ce qu'**on réalise la réaction dans un solvant.

8. Procédé selon la revendication 7, **caractérisé en ce qu'**on utilise des solvants polaires, aprotiques, comme la N-méthylpyrrolidone, le diméthylformamide, le tétrahydrofurane, le dioxane, les dialkyléthers, les glycoléthers, les cétones et/ou les esters.

9. Procédé selon la revendication 7, **caractérisé en ce qu'**on utilise comme solvant des hydrocarbures halogénés, des hydrocarbures aliphatiques, cycloaliphatiques et/ou aromatiques, seuls ou en mélanges.

10. Procédé selon une ou plusieurs des revendications 6 à 9, **caractérisé en ce qu'**on effectue la réaction à des températures comprises entre -10 et +200°C.

11. Procédé selon la revendication 10, **caractérisé en ce qu'**on effectue la réaction à des températures comprises entre 70 et 160°C.

12. Procédé selon une ou plusieurs des revendications 6 à 11, **caractérisé en ce que** le rapport équivalent entre le composé polyépoxyde (A) et l'acide dicarboxylique contenant du phosphore ou l'anhydride dicarboxylique contenant du phosphore (B) s'élève à entre 1 : 0,1 et 1:1.

13. Utilisation de la résine époxyde modifiée par du phosphore selon une ou plusieurs des revendications 1 à 5 ou obtenue selon l'une des revendications 6 à 12 pour la préparation de pièces moulées, de revêtements ou de stratifiés.
